# FASCICULE DE BREVET EUROPEEN

(11) **EP 0 478 440 B1**
(45) Date de publication et mention de la délivrance du brevet: **12.05.1993**
(21) Numéro de dépôt: 91402537.4
(22) Date de dépôt: 24.09.1991
(51) Int. Cl.: G11C 16/06, G11C 7/00

(54) **Circuit de précharge pour la lecture de mémoires**
Vorladeschaltung um einen Speicher zu lesen
Precharge circuit for reading a memory

(30) Priorité: 25.09.1990 FR 9011817
(43) Date de publication de la demande: 01.04.1992
(73) Titulaire: SGS-THOMSON MICROELECTRONICS S.A., 94250 Gentilly (FR)
(72) Inventeur: Gaultier, Jean-Marie, F-75116 Paris (FR)
(74) Mandataire: Schmit, Christian Norbert Marie

(56) Documents cités:
- EP-A- 0 204 488
- EP-A- 0 319 066
- EP-A- 0 329 141
- PATENT ABSTRACTS OF JAPAN, vol. 6, no. 75 (P-114)(953) 12 mai 1982, & JP-A-57 012 483 (NIPPON DENKI) 22 janvier 1982

## Description

L'invention concerne les circuits intégrés de mémoire. Elle s'applique notamment aux mémoires mortes programmables électriquement.

Les mémoires sont constituées de réseaux de cellules de mémoire agencées en lignes et colonnes. L'adressage se fait par exemple en ligne et la lecture se fait en colonne : une ligne de mot sert à adresser un ensemble de cellules situées sur une même ligne et connectées à cette ligne de mot; l'état de la cellule est lu sur un conducteur appelé "ligne de bit", ce conducteur étant connecté à un ensemble de cellules disposées le long d'une même colonne du réseau.

La lecture de l'état d'une cellule se fait de la manière suivante : on sélectionne par un décodeur la ligne dans laquelle se situe la cellule, et on connecte à un amplificateur de lecture la ligne de bit correspondant à cette cellule. La lecture se fait le plus souvent en deux temps :
- dans un premier temps on précharge la ligne de bit à un potentiel déterminé, par exemple environ 1 volt;
- dans un deuxième temps, on procède à la lecture proprement dite : la cellule reçoit les tensions appropriées et consomme ou non du courant suivant son état (vierge ou programmée), ce qui a pour conséquence de faire varier le potentiel AD en sortie d'un convertisseur courant-tension.

La lecture se fait par comparaison de la valeur AD et de la valeur correspondante fournie par un circuit de référence connecté à une cellule vierge.

Les circuits intégrés de mémoire de ce type comportent donc un circuit de précharge associé aux lignes de bit.

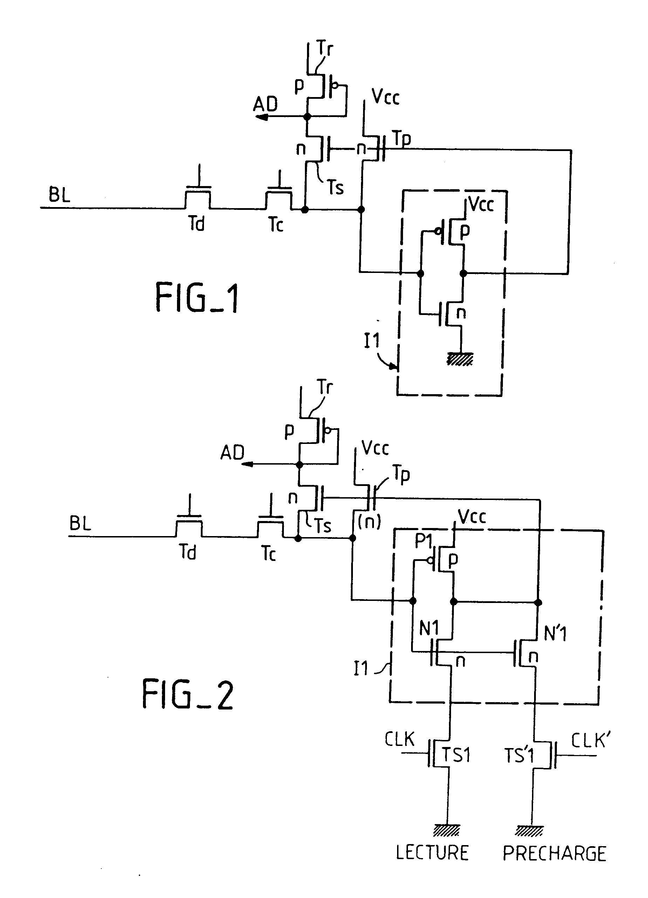

Dans les réalisations les plus simples de l'art antérieur, le circuit de précharge est constitué comme à la figure 1. Il est connecté entre la ligne de bit et l'amplificateur différentiel. Il sert à la fois à établir un potentiel de précharge sur la ligne de bit et à transmettre un signal à l'amplificateur de lecture. On peut donc l'appeler circuit de précharge et lecture.

Ce circuit est un convertisseur dit "circuit i/v". c'est un convertisseur courant-tension qui fournit une tension variant fortement avec le courant d'entrée. Il détecte le courant absorbé par la cellule au moment de la lecture (courant dépendant de l'état de mémorisation de la cellule); la tension de sortie du circuit, dépendant fortement du courant d'entrée, est appliquée à l'amplificateur différentiel de lecture qui bascule dans un sens ou dans un autre selon l'état de la cellule. Pendant la précharge, avant la lecture, c'est ce même circuit qui impose sur la ligne de bit une tension de précharge fixe.

Le circuit de la figure 1 comporte un transistor de précharge Tp ayant son drain connecté à la tension d'alimentation Vcc du circuit et sa source rebouclée sur sa grille à travers un inverseur I1 pour établir un asservissement imposant une tension fixe sur la source du transistor. L'inverseur est ici constitué de deux transistors MOS complémentaires ayant leurs grilles réunies pour constituer l'entrée de l'inverseur, entrée connectée à la source de Tp, et leurs drains réunis pour constituer la sortie de l'inverseur, sortie connectée à la grille de Tp. Les caractéristiques (tension de seuil et dimensions) du transistor de précharge Tp et celles des transistors de l'inverseur fixent la valeur de la tension de précharge que le circuit i/v tend à imposer sur la ligne de bit pendant la précharge.

La source du transistor Tp, constitue l'entrée du convertisseur i/v et elle est reliée à la ligne de bit BL, par l'intermédiaire de transistors nécessaires par ailleurs au fonctionnement de la mémoire : notamment un transistor Tc de commande de lecture, et un transistor Td de décodage de la ligne de bit. Un transistor Ts, ayant sa source et sa grille connectés à la source et à la grille du transistor Tp et de même type (canal n ici) que Tp recopie le courant dans le transistor Tp. Le transistor Ts est en série avec un transistor Tr monté en résistance et relié à la tension d'alimentation Vcc. Tr est de préférence un transistor à canal p ayant sa grille connectée à son drain. La sortie du convertisseur est le point de jonction des drains des transistors Tr et Ts et fournit un potentiel AD représentatif du courant consommé par le transistor Tp c'est-à-dire du courant consommé sur la ligne de bit BL.

Pendant la phase de précharge, les transistors Tc et Td sont conducteurs et se comportent comme des résistances. La ligne de bit se comporte comme une capacité de valeur relativement élevée car tous les points mémoire d'une colonne entière sont raccordés en parallèle à cette ligne de bit. Il en résulte que la ligne de bit se précharge relativement lentement, en tendant exponentiellement vers la valeur de consigne imposée par le transistor Tp et son inverseur de rebouclage.

La lenteur de la précharge est un inconvénient car elle diminue le temps d'accès global pour la lecture d'une cellule de mémoire. Pour une mémoire de temps d'accès 80 nanosecondes, le temps de précharge peut durer par exemple 25 nanosecondes. Il serait souhaitable de réduire ce temps, soit pour disposer de plus de temps pour la lecture proprement dite, soit pour réduire le temps d'accès total.

Un but de l'invention est de minimiser le temps de précharge de ligne de bit tout en conservant les mêmes performances en lecture et sans rendre le circuit de lecture trop complexe.

Pour cela, l'invention propose de donner au circuit de rebouclage du circuit de précharge des caractéristiques différentes pendant la phase de précharge et pendant la phase de lecture proprement dite, de manière que le circuit impose pendant la précharge une consigne de tension de précharge plus élevée que la consigne fournie pendant la lecture proprement dite.

Un objet de l'invention est donc notamment un circuit de précharge et lecture pour une mémoire en circuit intégré, comportant un transistor de précharge adapté pour être connecté à une ligne de bit et un inverseur dont l'entrée est adaptée pour être connecté à la ligne de bit et dont la sortie est connectée à la grille du transistor de précharge, le transistor et l'inverseur constituant un circuit d'asservissement imposant une consigne de tension de précharge vers laquelle tend la tension de la ligne de bit, cette consigne de tension étant liée aux caractéristiques du circuit d'asservissement, caractérisé en ce qu'il est prévu des moyens pour modifier, pendant une phase de précharge, les caractéristiques du circuit d'asservissement de la tension de précharge, pour établir momentanément une consigne de tension plus élevée que la tension de précharge désirée pour la lecture, et revenir ensuite à une consigne de tension sensiblement égale à la valeur de précharge désirée.

Un circuit de séquencement est donc prévu pour modifier la structure de l'inverseur pendant ces deux phases. La durée de la première phase est choisie de préférence de manière à se terminer lorsque la tension sur la ligne de bit atteint sensiblement la valeur de précharge désirée pour la phase de lecture.

De préférence, l'inverseur comporte un transistor à canal P en série avec un transistor à canal N, et un moyen pour modifier la dimension de l'un des transistors de l'inverseur selon la phase en cours.

Par exemple, ce transistor est en réalité constitué de deux transistors en parallèle de dimensions différentes qui sont connectés en parallèle, l'un étant sélectionné pendant l'une des phases et l'autre pendant l'autre phase. Par exemple, la source de l'un des transistors en parallèle est reliée à une borne d'alimentation à travers un premier transistor de sélection tandis que la source de l'autre est reliée à la même borne par l'intermédiaire de l'autre transistor de sélection.

Pendant la phase de précharge, le circuit de précharge peut fournir un courant important et charger plus vite la ligne de bit à la tension fixe désirée. Pendant la lecture, on revient à une structure et des dimensions de transistors qui imposent une consigne de précharge très proche de la valeur de précharge désirée, et qui donnent un grand gain courant/tension pour la lecture.

Les caractéristiques et avantages de l'invention apparaîtront à la lecture de la description détaillée qui suit et qui est faite en référence aux dessins annexés dans lesquels :
- la figure 1, déjà décrite, représente un circuit de lecture et précharge déjà utilisé avant l'invention;
- la figure 2 représente un exemple de circuit selon l'invention;
- la figure 3 représente une courbe de montée de la tension de précharge sur la ligne de bit avec le circuit de la figure 1;
- la figure 4 représente une courbe de montée de la tension de précharge avec le circuit de la figure 2.

Les éléments correspondant à ceux de la figure 1 sont désignés sur la figure 2 par les mêmes références : la ligne de bit BL, connectée au circuit de précharge et lecture par l'intermédiaire d'un transistor Td de décodage et d'un transistor Tc de commande de lecture, le transistor de précharge Tp qui fournit la tension de précharge désirée d'environ 1 volt par exemple, et enfin les transistors Tr et Ts permettant la conversion courant tension proprement dite.

L'inverseur I1 de la figure 1 est remplacé selon l'invention par un circuit légèrement plus complexe, qui joue le même rôle mais qui a des caractéristiques qui varient entre la phase de précharge et la phase de lecture proprement dite.

Cet inverseur comprend dans cet exemple toujours un transistor P1 à canal P en série avec un transistor à canal N. Mais en fait il y a deux transistors N1 et N'1 en parallèle, l'un au moins pouvant être mis hors circuit. Dans l'exemple représenté, soit l'un soit l'autre des transistors est en service. Mais on pourrait aussi prévoir que pendant la phase de lecture les deux transistors sont en service en parallèle.

Chacun des transistors N1 et N'1 est en série avec un transistor de sélection respectif TS1, TS'1 qui permet de mettre à la masse la source du transistor N1 ou N'1 respectivement. Le transistor de sélection TS1 est rendu conducteur pendant la phase de lecture proprement dite, après la précharge. Le transistor TS'1 au contraire est rendu conducteur pendant la phase de précharge.

Ainsi, pendant la précharge, l'inverseur est constitué pratiquement par les transistors P1 et N'1 (ou plus précisément P1 et l'ensemble N'1/TS'1); pendant la phase de lecture proprement dite, l'inverseur est constitué par les transistors P1 et N1/TS1.

On établit alors un signal de séquencement qui rend conducteur TS1 ou TS'1 pendant des durées déterminées.

De la même manière qu'à la figure 1, le rebouclage de la source vers le drain du transistor Tp à travers un inverseur constitue un asservissement tendant à imposer sur la source de Tp une tension fixe dont le niveau dépend essentiellement des caractéristiques (tension de seuil et dimensions) du transistor Tp et de celles des transistors de l'inverseur. Par "dimensions" des transistors, on entend essentiellement le rapport W/L entre la largeur et la longueur de canal du transistor.

On fait en sorte selon l'invention que pendant la phase de précharge la tension d'équilibre Vp'1 que tend à établir l'inverseur avec comme transistor à canal N le groupe N'1, TS'1 soit supérieure à la tension d'équilibre Vp1 que tend à établir l'inverseur avec comme transistor à canal N le groupe N1, TS1. Cette dernière tension d'équilibre est d'ailleurs très proche de la valeur de précharge désirée sur la ligne de bit, la tension Vp'1 étant au contraire nettement supérieure (par exemple 30% supérieure).

Au moment de la précharge, lorsque la ligne de bit à précharger est connectée par les transistors Td et Tc au circuit de précharge et lecture, la tension sur la ligne de bit tend exponentiellement vers la tension d'équilibre imposée par le transistor Tp rebouclé par l'inverseur.

Selon l'invention, pendant la phase de précharge on applique un signal d'horloge CLK' qui rend conducteur le transistor de sélection TS'1 pour faire fonctionner l'inverseur avec comme transistor à canal N le transistor N'1 (ou plus exactement le groupe N'1, TS'1). Le potentiel de la ligne de bit tend exponentiellement vers le potentiel Vp'1 plus élevé que ce qui est désiré.

La durée du signal d'horloge CLK' est de préférence calculée pour que le transistor TS'1 se bloque lorsque le potentiel de la ligne de bit a atteint sensiblement la valeur désirée. Un signal d'horloge CLK, de préférence tout simplement le complément logique de CLK', prend alors le relais pour rendre conducteur le transistor TS1.

Le transistor Tp et son inverseur (avec maintenant le transistor N1 comme transistor à canal N) tendent alors à établir sur la ligne de bit le potentiel Vp1. Comme ce potentiel était pratiquement déjà atteint par suite de la charge relativement rapide de la ligne de bit, le circuit est prêt pour la phase de lecture proprement dite. Pendant cette phase, le circuit d'asservissement est stabilisé au potentiel de précharge désiré Vp1 pour la lecture.

On accélère ainsi notablement la précharge sans changer les caractéristiques du circuit au moment de la lecture proprement dite.

Pour obtenir cette précharge rapide, on donnera en pratique au transistor N'1 utilisé pendant la précharge un rapport W/L (largeur sur longueur de canal) plus petit qu'au transistor N1; cela suppose que le transistor N'1 seul soit utilisé pendant la précharge et le transistor N1 seul soit utilisé ensuite.

On pourrait cependant aussi prévoir que pendant la précharge le transistor N'1 seul est utilisé et que pendant la lecture les transistors N1 et N'1 sont utilisés en parallèle pour former un plus gros transistor. Cela change évidemment les dimensions relatives à donner aux deux transistors.

On pourrait aussi jouer sur les dimensions relatives des transistors à canal P pour définir une tension de consigne Vp'1 plus grande pendant la précharge que la tension Vp1 de précharge réellement désirée. Et on pourrait aussi combiner une action sur le transistor à canal P et sur le transistor à canal N, voire même substituer un inverseur à un autre de constitution différente pour obtenir le même résultat.

On pourrait enfin éventuellement agir plutôt sur le transistor de précharge Tp lui-même plutôt que sur les transistors de l'inverseur.

On peut sécuriser le système en ajoutant en parallèle avec le circuit un limiteur de tension interdisant toute montée excessive de la tension sur la ligne de bit.

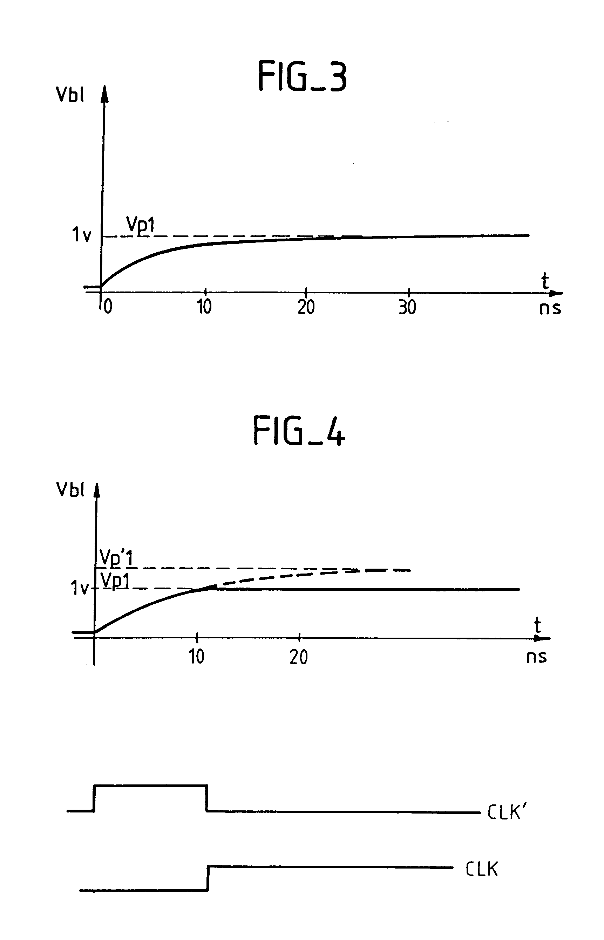

La figure 3 et la figure 4 représentent respectivement, à titre d'illustration pour aider à la compréhension, la montée de potentiel de la ligne de bit avec le circuit de la figure 1 et avec le circuit de la figure 2.

A la figure 3, correspondant au circuit de la figure 1, à partir de l'instant où la ligne de bit est connectée par les transistors Td et Tc au circuit de précharge et lecture, il faut attendre un temps qui peut être par exemple d'une trentaine de nanosecondes avant que le potentiel de la ligne de bit ait atteint à peu près la valeur de consigne désirée.

A la figure 4, la montée de potentiel est beaucoup plus rapide pendant le créneau de tension CLK' qui rend conducteur le transistor TS'1, et dès la fin de ce créneau ou presque (par exemple au bout de 10 à 12 nanosecondes) on peut effectuer la lecture car le potentiel de la ligne de bit est stabilisé à la bonne valeur.

Les valeurs numériques données supposent que dans les deux cas on vise à obtenir le même potentiel de précharge, avec les mêmes caractéristiques de capacité et résistances de connexion de la ligne de bit.

## Revendications

1. Circuit de précharge et lecture pour une mémoire en circuit intégré, comportant un transistor de précharge (Tp) adapté pour être connecté à une ligne de bit (BL) et un inverseur (I1) dont l'entrée est adaptée pour être connecté à la ligne de bit (BL) et dont la sortie est connectée à la grille du transistor de précharge, le transistor et l'inverseur constituant un circuit d'asservissement imposant une consigne de tension de précharge vers laquelle tend la tension de la ligne de bit, cette consigne de tension étant liée aux caractéristiques du circuit d'asservissement, caractérisé en ce qu'il est prévu des moyens (TS1, TS2, N'1) pour modifier, pendant une phase de précharge, les caractéristiques du circuit d'asservissement de la tension de précharge, pour établir momentanément une consigne de tension (Vp'1) plus élevée que la tension de précharge désirée pour la lecture, et revenir ensuite à une consigne de tension (Vp1) sensiblement égale à la valeur de précharge désirée.

2. Circuit de précharge et lecture selon la revendication 1, caractérisé en ce que les moyens pour modifier momentanément les caractéristiques du circuit d'asservissement sont prévus pour agir jusqu'à ce que la tension sur la ligne de bit soit sensiblement égale à la tension de précharge désirée.

3. Circuit de précharge selon l'une des revendications 1 et 2, caractérisé en ce que l'inverseur comporte deux transistors (P1, N1) en série de types de conductivité opposés, et au moins un transistor supplémentaire (N'1) en parallèle sur l'un des deux, avec des moyens (TS1, TS'1) pour connecter ou déconnecter le transistor supplémentaire.

4. Circuit de précharge et lecture selon la revendication 3, caractérisé en ce que l'inverseur comporte deux transistors à canal N en parallèle (N1 et N'1) et en ce qu'il est prévu deux transistors de sélection (TS1 et TS'1) pour mettre en service soit l'un soit l'autre des transistors à canal N selon qu'on est en phase de précharge ou en phase de lecture.

## Patentansprüche

1. Schaltung zum Vorladen und Lesen eines in Form einer integrierten Schaltung ausgeführten Speichers, mit einem Vorladungstransistor (Tp), der an eine Bitleitung (BL) anschließbar ist, und einem Invertierglied (I1), dessen Eingang an die Bitleitung (BL) und dessen Ausgang an das Gate des Vorladungstransistors anschließbar sind, wobei der Transistor und das Invertierglied eine Regelschaltung bilden, die einen Einstellwert der Vorladungsspannung einprägt, gegen den die Spannung an der Bitleitung strebt, wobei dieser Spannungseinstellwert an die Kenngrößen der Regelschaltung gebunden ist, dadurch gekennzeichnet, daß Mittel (TS1, TS2, N'1) vorgesehen sind, um während einer Vorladungsphase die Kenngrößen der Regelschaltung der Vorladungsspannung zu modifizieren, damit momentan ein Spannungseinstellwert (Vp'1) erzielt wird, der höher als die zum Lesen gewünschte Vorladungsspannung ist, worauf dann wieder zu einem Spannungseinstellwert (Vp1) zurückgekehrt wird, der im wesentlichen gleich dem gewünschten Vorladungswert ist.

2. Schaltung zum Vorladen und Lesen nach Anspruch 1, dadurch gekennzeichnet, daß die Mittel zum momentanen Modifizieren der Kenngrößen der Regelschaltung vorgesehen sind, um solange zu wirken, bis die Spannung an der Bitleitung im wesentlichen gleich der gewünschten Vorladungsspannung ist.

3. Schaltung zum Vorladen nach einem der Ansprüche 1 und 2, dadurch gekennzeichnet, daß das Invertierglied zwei in Serie geschaltete Transistoren (P1, N1) mit entgegengesetzten Leitungstypen und wenigstens einen zusätzlichen Transistor (N'1) parallel zu einem der beiden enthält, wobei Mittel (TS1, TS'1) vorgesehen sind, um den zusätzlichen Transistor anzuschließen oder abzutrennen.

4. Schaltung zum Vorladen und Lesen nach Anspruch 3, dadurch gekennzeichnet, daß das Invertierglied zwei parallel geschaltete N-Kanal-Transistoren (N1 und N'1) enthält und daß zwei Auswahltransistoren (TS1 und TS'1) vorgesehen sind, um den einen oder den anderen der N-Kanal-Transistoren abhängig davon in Betrieb zu setzen, ob die Vorladungsphase oder die Lesephase vorliegt.

## Claims

1. A pre-charging and reading circuit for an integrated circuit memory, comprising a pre-charging transistor (Tp) adapted to be connected to a bit line (BL) and an inverter (I1) whose input is adapted to be connected to the bit line (BL) and whose output is connected to the gate of the pre-charging transistor, the transistor and the inverter constituting a servo-control circuit which imposes a set value of pre-charging voltage towards which the voltage of the bit line tends, this set voltage value being related to the characteristics of the servo-control circuit, characterized in that provision is made for means (TS1, TS2, N'1) for modifying the characteristics of the pre-charging voltage servo-control circuit during a pre-charging phase, in order to establish momentarily a higher set voltage value (Vp'1) than the desired pre-charging voltage for reading, and then return to a set voltage value (Vp1) substantially equal to the desired pre-charging value.

2. A pre-charging and reading circuit according to Claim 1, characterized in that the means for modifying momentarily the , characterisics of the servo-control circuit are so designed that they remain effective until the voltage on the bit line is substantially equal to the desired pre-charging voltage.

3. A pre-charging circuit according to one of the Claims 1 and 2, characterized in that the inverter has two transistors (P1, N1) in series with opposite types of conductivity, and at least one additional transistor (N'1) in parallel with one of the two of them, with means (TS1, TS'1) for connecting or disconnecting the additional transistor.

4. A pre-charging and reading circuit according to Claim 3, characterized in that the inverter has two N channel transistors in parallel (N1 and N'1), and in that two selection transistors (TS1 and TS'1) are provided to bring into operation either one or the other channel N transistor according to whether the pre-charging or the reading stage is in progress.
